# EUROPEAN PATENT APPLICATION

(11) **EP 4 582 199 A1**
(43) Date of publication of application: **09.07.2025**
(21) Application number: 23860069.6
(22) Date of filing: 17.08.2023
(51) Int. Cl.: B23B 27/14, B23C 5/16, C23C 14/06

(54) **COATED TOOL**

(30) Priority: 29.08.2022 JP 2022135974
(71) Applicant: MOLDINO Tool Engineering, Ltd., Tokyo 130-0026 (JP)
(72) Inventor: SASAKI, Tomoya, Narita-shi, Chiba 286-0825 (JP)
(74) Representative: Hoffmann Eitle
(86) International application number: PCT/JP2023/029736
(87) International publication number: WO 2024/048306

(57) **Abstract**

A coated tool includes a substrate and a hard coating on the substrate. The hard coating includes an A layer provided on the substrate and a B layer provided on the A layer. The A layer is a nitride or a carbonitride containing 50 atom% or more and 70 atom% or less of Al and 30 atom% or more and 50 atom% or less of Cr with respect to a total amount of metal elements including metalloid elements. The B layer is a nitride or a carbonitride containing 70 atom% or more and 85 atom% or less of Al and 15 atom% or more and 30 atom% or less of Cr with respect to a total amount of metal elements including metalloid elements. The B layer is finer than the A layer. In the B layer, streaky phases having different brightnesses are confirmed in observation with a transmission electron microscope. The phases having different brightnesses have a region having a relatively high Al content and a region having a relatively low Al content. The A layer and the B layer contain Ar.

## Description

### TECHNICAL FIELD

The present invention relates to a coated tool applied to a tool such as a mold or a cutting tool.

Priority is claimed on Japanese Patent Application No. 2022-135974, filed August 29, 2022, the content of which is incorporated herein by reference.

### BACKGROUND ART

An AlCr nitride is a film type having excellent wear resistance and heat resistance, and is widely applied to coated molds or coated cutting tools. In recent years, coated tools coated with an Al-rich AlCr nitride having an Al content ratio of more than 70 atom% using an arc ion plating method have started to be proposed (Patent Documents 1 to 3).

### Citation List

### Patent Documents

Patent Document 1: Japanese Unexamined Patent Application, First Publication No. 2016-032861
Patent Document 2: Japanese Unexamined Patent Application, First Publication No. 2018-059146
Patent Document 3: Japanese Unexamined Patent Application, First Publication No. 2020-040175

### SUMMARY OF INVENTION

### Technical Problem

In a small-diameter tool having a tool diameter of 2 mm or less, the influence of droplets on the tool performance is likely to become large. The present inventors have confirmed that an Al-rich AlCr nitride, the coating of which is performed by an arc ion plating method, is likely to have many droplets, and there is room for improvement in the durability of a tool.

The number of droplets can be reduced by using a sputtering method in the formation of a hard coating. However, in a case where a hard coating is simply formed using the sputtering method, wear resistance may be inferior to that of a hard coating formed using the arc ion plating method.

The present invention has been made in view of the above-described circumstances, and an object of the present invention is to provide a coated tool that realizes durability equal to or higher than in the case of using an arc ion plating method while reducing the number of droplets through the application of a sputtering method, for an Al-rich AlCr nitride or carbonitride.

### Solution to problem

A coated tool according to an aspect of the present invention is a coated tool including a substrate and a hard coating on the substrate, in which the hard coating includes an A layer provided on the substrate and a B layer provided on the A layer, the A layer is a nitride or a carbonitride containing 50 atom% or more and 70 atom% or less of Al and 30 atom% or more and 50 atom% or less of Cr with respect to a total amount of metal elements including metalloid elements, the B layer is a nitride or a carbonitride containing 70 atom% or more and 85 atom% or less of Al and 15 atom% or more and 30 atom% or less of Cr with respect to a total amount of metal elements including metalloid elements, the B layer is finer than the A layer, in the B layer, streaky phases having different brightnesses are confirmed in observation with a transmission electron microscope, the phases having different brightnesses have a region having a relatively high Al content and a region having a relatively low Al content, and the A layer and the B layer contain Ar.

### Advantageous Effects of Invention

According to the present invention, it is possible to obtain the coated tool provided with a sputtered coating of an Al-rich AlCr nitride or carbonitride and having excellent durability.

### BRIEF DESCRIPTION OF DRAWINGS

[FIG. 1] A bright field STEM image (× 40,000-fold) of a hard coating according to Example 1.
[FIG. 2] A dark field STEM image (× 40,000-fold) of the hard coating according to Example 1.
[FIG. 3] A cross-sectional TEM image (× 40,000-fold) of an A layer according to Example 1.
[FIG. 4] A cross-sectional TEM image (× 40,000-fold) of a B layer according to Example 1.

### DESCRIPTION OF EMBODIMENTS

The present inventors have confirmed that durability of a coated tool is excellent for a sputtered coating for an Al-rich AlCr nitride or carbonitride having a specific microstructure. Hereinafter, the details of an embodiment of the present invention will be described.

A coated tool of the present embodiment is a coated tool including an A layer consisting of columnar crystals formed on a substrate and a B layer consisting of columnar crystals and fine crystals formed on the A layer. The coated tool of the present embodiment can be applied to molds or cutting tools. Particularly, the present invention is applied to small-diameter end mills having a tool diameter of preferably 5 mm or less, still more preferably 3 mm or less.

In the present example, the substrate is not particularly limited. Cold tool steel, hot tool steel, high-speed steel, cemented carbide, or the like may be applied according to the application as appropriate. The substrate may be subjected to a nitriding treatment, a bombardment treatment, or the like in advance.

First, the A layer will be described.

The A layer is provided on the substrate. The A layer is a nitride or a carbonitride containing 50 atom% or more and 70 atom% or less of Al and 30 atom% or more and 50 atom% or less of Cr with respect to the total amount of metal (including metalloids and the same applies hereinafter) elements. A nitride or carbonitride mainly composed of Al and Cr has an excellent balance between wear resistance and heat resistance, and also has excellent adhesion to the substrate.

In the A layer, when the total amount of the metal elements constituting the A layer is set to 100 atom%, the Al content ratio is set to 50 atom% or more. Furthermore, in the A layer, the Al content ratio is preferably 55 atom% or more. On the other hand, when the Al content ratio is too large, the toughness of the hard coating is reduced. Therefore, in the A layer, the Al content ratio is set to 70 atom% or less. Furthermore, in the A layer, the Al content ratio is preferably 65 atom% or less.

In the A layer, the Cr content ratio is set to 30 atom% or more. As a result, the durability of the A layer is improved, and the adhesion to the substrate is improved. Furthermore, in the A layer, the Cr content ratio is preferably set to 35 atom% or more. On the other hand, when the Cr content ratio is too large, the Al content ratio is relatively low, and the heat resistance of the A layer is lowered. Therefore, in the A layer, the Cr content ratio is set to 50 atom% or less. Furthermore, in the A layer, the Cr content ratio is preferably 45 atom% or less.

The A layer consists of columnar crystals. The crystal structure of the A layer consists of cubic crystals. The columnar crystal of the A layer extends along a film thickness direction of the hard coating. The A layer provided on the substrate consists of columnar crystals, whereby the adhesion is improved. The average crystal grain size of the A layer is preferably 120 nm or more and 300 nm or less. That is, the average width of the columnar crystals of the A layer is preferably 120 nm or more and 300 nm or less. The average crystal grain size of the A layer or the average width of the columnar crystals can be acquired from a cross-sectional observation image obtained using a transmission electron microscope. The width of the columnar crystal of the A layer is the length of the columnar crystal in a direction orthogonal to a direction in which the columnar crystal extends (substantially the film thickness direction). The average width of the columnar crystals is calculated using a width measured in a central portion of the hard coating in the film thickness direction. The central portion in the film thickness direction refers to a portion in a range of 10% or less on both sides in the film thickness direction from the center of the hard coating in the film thickness direction. The central portion of the A layer in the film thickness direction is a portion in a range of 10% or less of the film thickness of the A layer on both sides in the film thickness direction from the center of the A layer in the film thickness direction. The average width of the columnar crystals is calculated as an average value of widths of 10 or more columnar crystals confirmed by the cross-sectional observation image.

The film thickness of the A layer is preferably 0.3 µm or more and 3 µm or less.

The A layer may contain metal elements other than Al and Cr. For example, for the purpose of improving wear resistance and heat resistance, the A layer can also contain one element or two or more elements selected from elements of Groups 4a, 5a, and 6a of the periodic table and Si, B, Y, Yb, and Cu. These elements are generally contained to improve coating properties of the coated tool, and can be added within a range that does not significantly deteriorate the durability of the coated tool. However, when the content ratios of the metal elements other than Al and Cr are too large, the durability of the coated tool may be deteriorated. For this reason, in a case where the A layer contains metal elements other than Al and Cr, the total content ratio thereof is preferably 10 atom% or less, more preferably 5 atom% or less.

Next, the B layer will be described.

The B layer is provided on the A layer. The B layer is a nitride or a carbonitride containing 70 atom% or more and 85 atom% or less of Al and 15 atom% or more and 30 atom% or less of Cr with respect to the total amount of metal elements.

In the B layer, the Al content ratio is 70 atom% or more. By increasing the amount of Al contained in the B layer, an oxidation protection film is easily formed on the tool surface, and the coating structure is made fine, so that wear of the hard coating due to welding is easily suppressed. Furthermore, in the B layer, the Al content ratio is preferably 75 atom% or more. On the other hand, when the Al content ratio is too large, the toughness of the hard coating is significantly reduced.

Therefore, in the B layer, the Al content ratio is set to 90 atom% or less. Furthermore, in the B layer, the Al content ratio is preferably 85 atom% or less.

In the B layer, the Cr content ratio is set to 10 atom% or more. Accordingly, a uniform and dense oxidation protection film is easily formed on the tool surface during processing, and damage to the tool is easily suppressed. Furthermore, in the B layer, the Cr content ratio is preferably set to 15 atom% or more. On the other hand, when the Cr content ratio is too large, the Al content ratio is relatively low, and it is difficult to obtain an effect of increasing the Al content ratio. Therefore, in the B layer, the Cr content ratio is set to 30 atom% or less. Furthermore, in the B layer, the Cr content ratio is preferably 25 atom% or less.

The B layer may contain metal elements other than Al and Cr. For example, for the purpose of improving wear resistance and heat resistance, the B layer can also contain one element or two or more elements selected from elements of Groups 4a, 5a, and 6a of the periodic table and Si, B, Y, Yb, and Cu. These elements are generally contained to improve coating properties of the coated tool, and can be added within a range that does not significantly deteriorate the durability of the coated tool. However, when the content ratios of the metal elements other than Al and Cr are too large, the durability of the coated tool may be deteriorated. For this reason, in a case where the B layer contains metal elements other than Al and Cr, the total content ratio thereof is preferably 10 atom% or less, more preferably 5 atom% or less.

The B layer is finer than the A layer. That is, the average crystal grain size of the B layer is smaller than the average crystal grain size of the A layer. The B layer may be configured to consist of crystal grains having a grain size smaller than the average crystal grain size of the A layer. The B layer may be configured to consist of crystal grains smaller than the crystal grains of the A layer. By making the structure of the B layer fine, the wear of the hard coating due to welding is easily suppressed. In addition, the oxidation protection film is likely to be uniformly formed on the tool surface.

In the present embodiment, the B layer consists of columnar crystals and fine crystals. It is preferable that the columnar crystals of the B layer has an average crystal grain size of 50 nm or less and the fine crystal has an average crystal grain size of 10 nm or less. A method of calculating the average crystal grain size of the columnar crystals of the B layer is the same as the method of calculating the average crystal grain size of the A layer described above. The average crystal grain size of the fine crystals of the B layer can be measured from the cross-sectional observation image of the transmission electron microscope using an intercept method or an area measurement method.

In the B layer, streaky phases having different brightnesses are confirmed in the observation with the transmission electron microscope. In the streaky phases having different brightnesses, streaky bright regions and streaky dark regions are observed in a mixed manner. The phases having different brightnesses have regions having a relatively high Al content and regions having a relatively low Al content. The streaky phases having different brightnesses each extend over the film thickness direction of the B layer. The direction in which the streaky phases having different brightnesses extend may be a direction inclined with respect to the film thickness direction of the B layer. The crystal structure of the B layer consists of cubic crystals and hexagonal crystals. The region having a relatively high Al content has a larger amount of hexagonal AlN than that in the region having a relatively low Al content.

The film thickness of the B layer is preferably 0.5 µm or more and 3 µm or less. The B layer is preferably a film thicker than the A layer.

It is preferable that the boundary between the A layer and the B layer is uneven. It is preferable that the boundary between the A layer and the B layer has larger unevenness than the upper surface of the B layer and the surface of the substrate. The uneven boundary can be confirmed by cross-sectional observation with the transmission electron microscope. In a case where the boundary between the A layer and the B layer is uneven, the adhesion between the A layer and the B layer having different grain sizes can be further enhanced. It is preferable that the boundary between the A layer and the B layer has a plurality of uneven portions having a length of 0.1 µm or more from the top portion to the bottom portion. The length from the top portion to the bottom portion may be 0.3 µm or more.

The A layer and the B layer are sputtered coatings and contain argon (Ar). Due to the sputtered coating, the frequency of occurrence of droplets, which are defects of the hard coating, can be reduced. In order to stabilize the coating characteristics, the A layer and the B layer preferably contain argon in an amount of 0.01 atom% or more with respect to the total amount of the metal element and non-metal element. Furthermore, it is preferable that the A layer and the B layer contain argon in an amount of 0.05 atom% or more.

An increase in the amount of argon may cause defects. The A layer and the B layer preferably contain argon in an amount of 0.80 atom% or less with respect to the total amount of the metal element and the non-metal element. Furthermore, the argon content ratio is preferably set to 0.70 atom% or less. The B layer having a fine structure is likely to contain a more amount of argon than the A layer.

When sputtering is performed using a mixed gas containing a rare gas other than argon, the hard coating according to the present embodiment may also contain the rare gas other than argon.

Similarly to the above-mentioned measurement of the content ratios of the metal element, the argon content ratio of the hard coating according to the present embodiment can be measured for the mirror-finished hard coat using an electron probe micro analyzer (EPMA). Similarly to the above-mentioned measurement of the content ratios of the metal elements, after mirror-finishing, analysis was performed at five points where each analysis range is approximately 1 µm in diameter, and the argon content ratio can be obtained from an average of the analysis results.

The hard coating according to the present embodiment may contain very small amounts of argon, oxygen, and carbon as non-metal elements in addition to nitrogen.

### <Interlayer Coating and Upper Layer>

In the coated tool of the present embodiment, in order to further improve adhesion of the hard coating, an intermediate coating may be separately provided between the substrate of the tool and the hard coating, if necessary. For example, a layer made of any of metal, nitride, carbonitride, and carbide may be provided between the substrate of the tool and the hard coating.

In addition, a hard coating having a different component ratio or a different composition from the hard coating according to the present embodiment may be separately formed on the hard coating according to the present embodiment. Furthermore, the hard coating according to the present embodiment and a separate hard coating having a different composition ratio or a different composition from the hard coating according to the present embodiment may be laminated on each other.

### <Manufacturing Method>

In coating with the hard coating according to the present embodiment, it is preferable to apply a sputtering method in which three or more AlCr alloy targets are used, electric power is sequentially applied to the targets, and when the target to which electric power is applied is switched, a time for which electric power is simultaneously applied to both the target to which the application of electric power is ended and the target to which the application of electric power is started is provided. In such a sputtering method, a state where the ionization rates of target materials are high is maintained during coating, hard coatings that are dense at micro level are obtained, and there is a tendency that argon or oxygen which are inevitably contained is small in content. Then, it is preferable that the internal furnace temperature of a sputtering apparatus is set to 350°C to 500°C, the negative pressure bias voltage applied to the substrate is set to -170 V to -40 V, and Ar gas and N₂ gas are introduced to set the internal furnace pressure to 0.1 Pa to 0.4 Pa. In the case of coating with a carbonitride, a very small amount of carbon may be added to the target, or some of the reaction gas may be replaced with methane gas.

The maximum electric power density of an electric power pulse is preferably set to 0.1 kW/cm² or more. The maximum electric power density is further preferably set to 0.3 kW/cm² or more. In addition, in the present composition system, when the energy of film-forming ions is too high, the hexagonal crystals become too abundant. For this reason, the maximum electric power density of an electric power pulse is preferably set to 0.8 kW/cm² or less. The time of application of the electric power pulse to individual targets is preferably set to 30 milliseconds or less. In addition, the time for which electric power is simultaneously applied to both the alloy target to which the application of electric power is ended and the alloy target to which the application of electric power is started is preferably set to 20 microseconds or more and 100 microseconds or less.

The same AlCr-based alloy target may be used for coating of the A layer and the B layer.

By changing the maximum electric power density to change the ionization rate of the target material, it is possible to adjust the composition of the coating. In the sputtering of the AlCr alloy target, Cr is relatively easily ionized, and Al is relatively difficult to be ionized. Therefore, in a case where the maximum electric power density of the electric power pulse is small, the amount Al of the hard coating may be smaller than that of the target composition. In a case of coating of the hard coating according to the present invention, the same AlCr-based alloy target is used for the coating of the A layer and the B layer, the maximum electric power density of the electric power pulse may be set to be small in the coating of the A layer, while the maximum electric power density of the electric power pulse may be set to be large in the coating of the B layer. In addition, the A layer and the B layer may be coated with AlCr-based alloy targets having different compositions.

### Examples

### <Substrate>

As a substrate, a 2-flute ball end mill made of a cemented carbide having a composition of WC (Bal.)-Co (8.0% by mass)-VC (0.3% by mass)-Cr₃C₂ (0.5% by mass) and a hardness of 94.0 HRA (Rockwell hardness, a value measured in accordance with JIS G 0202) was prepared.

In Example 1, a sputtering apparatus in which six sputtering evaporation sources can be mounted was used. Among these vapor deposition sources, six Al75Cr25 alloy targets (the numerical values are atomic ratios, the same applies hereinafter) were installed in the apparatus as vapor deposition sources to perform the coating of a hard coating.

A tool that was the substrate was fixed to a sample holder in the sputtering apparatus, and a bias power supply was connected to the tool. The bias power supply has a structure in which a negative bias voltage is applied to the tool independently of the target. The tool rotates at two revolutions per minute, and revolves via a fixing jig and the sample holder. The distance between the tool and the target surface was set to 100 mm.

As introduction gases, Ar and N₂ were used, and the introduction gases were introduced from a gas supply port provided in the sputtering apparatus.

### <Bombardment Treatment>

First, before the tool was coated with a hard coating, a bombardment treatment was performed on the tool in the following procedure. Heating was performed for 30 minutes in a state where the internal furnace temperature was set to 400°C by a heater in the sputtering apparatus. Thereafter, the inside of the furnace of the sputtering apparatus was evacuated to set the internal furnace pressure to 5.0 × 10⁻³ Pa or less. Then, an Ar gas was introduced into the furnace of the sputtering apparatus, and the internal furnace pressure was adjusted to 0.8 Pa.

Then, a DC bias voltage of -170 V was applied to the tool, and cleaning (bombardment treatment) was performed on the tool by Ar ions for 20 minutes or more.

### <Coating of Hard Coating>

In the coating of Example 1, the internal furnace temperature was set to 400°C, and Ar gas (0.16 Pa) and N₂ gas (0.10 Pa) were introduced into the furnace of the sputtering apparatus to set internal furnace pressure to 0.26 Pa. A DC bias voltage was applied to the substrate, the overlapping time of electric power applied to the target was set to 50 microseconds, the discharge time per cycle of electric power applied to each target was set to 0.2 milliseconds, and the maximum electric power density was set to 0.4 kW/cm². Then, the negative pressure bias voltage applied to the substrate was set to -60 V, and electric power was continuously applied to the six Al75Cr25 alloy targets to coat the substrate with an A layer of approximately 1.0 µm.

Next, the maximum electric power density applied to each target was set to 0.8 kW/cm², and the A layer was coated with a B layer of approximately 2.0 µm.

In Comparative Example 1, an arc ion plating apparatus was used. An A160Cr40 alloy target was installed in the apparatus as a vapor deposition source. First, cleaning (bombardment treatment) was performed on the tool by Ar ions. Next, the internal furnace pressure of the arc ion plating apparatus was set to 5.0 × 10⁻³ Pa or less by evacuation, the internal furnace temperature was set to 500°C, and N2 gas was introduced to set the internal furnace pressure to 3.2 Pa. Next, a DC bias voltage of -100 V was applied to the tool, and a current of 150 A was applied to the A160Cr40 alloy target to coat the surface of the tool with a hard coating of approximately 3.0 µm. Comparative Example 1 has a composition generally used in the market.

The hard coating was analyzed by wavelength-dispersive electron probe microanalysis (WDS-EPMA) attached to an electron probe micro analyzer (JXA-8500F manufactured by JEOL Ltd.). The acceleration voltage was set to 10 kV, the irradiation current was set to 5 × 10⁻⁸ A, the acquisition time was set to 10 seconds, and measurement was performed at five points where each analysis region is 1 µm in diameter. In Example 1, the average composition of the A layer was Al65Cr35N (atomic ratio), and the average composition of the B layer was Al75Cr25N (atomic ratio).

In addition, the A layer contained 0.36 atom% of Ar and the B layer contained 0.55 atom% of Ar with respect to the total amount of the metal elements and the non-metal elements.

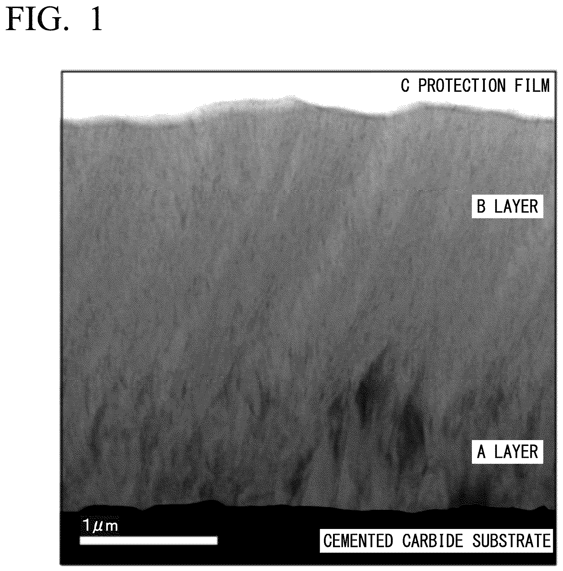

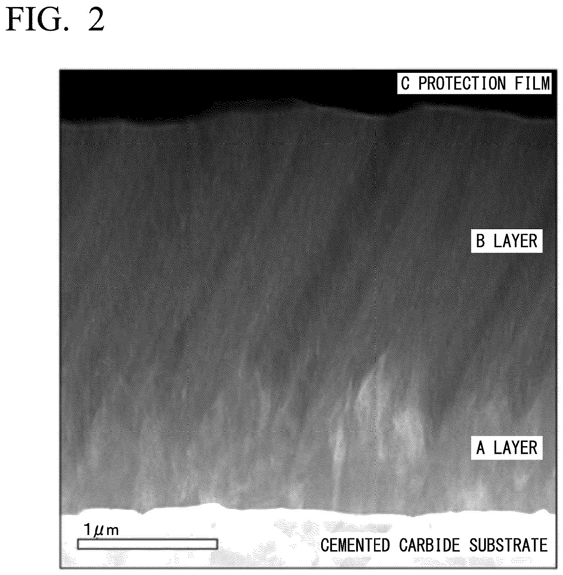

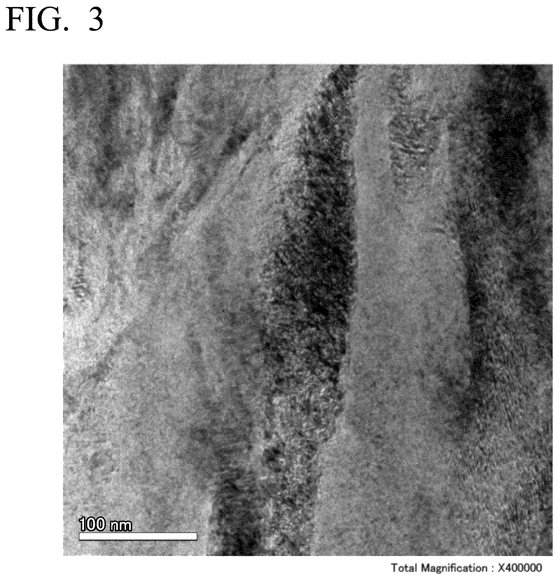

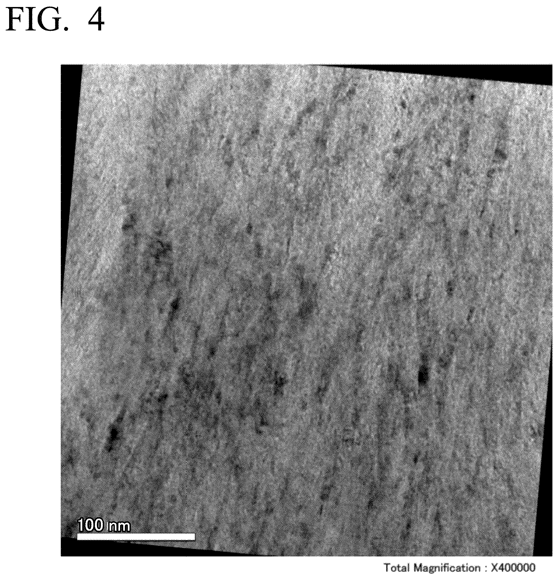

A microanalysis was performed on Example 1 with a transmission electron microscope. FIG. 1 shows a bright field STEM image, and FIG. 2 shows a dark field STEM image. The A layer on the substrate side and the B layer thereon are confirmed. It is confirmed that the B layer is finer than the A layer. FIG. 3 shows a cross-sectional TEM image of the A layer. FIG. 4 shows a cross-sectional TEM image of the B layer. The A layer consisted of columnar crystals, and the B layer consisted of columnar crystals and fine crystals. In the B layer, streaky phases having different brightnesses are confirmed. The crystal structure of the A layer consisted of cubic crystals. The crystal structure of the B layer consisted of cubic crystals and hexagonal crystals. In a case where the phases having different brightnesses were analyzed, regions that appeared bright in FIG. 1 had a relatively high Al content, and regions that appeared dark had a relatively low Al content. The region having a relatively high Al content had a larger amount of hexagonal AlN than that in the region having a relatively low Al content.

### (Condition) Dry processing

Tool: 2-flute carbide ball end mill
Model number: EPDBE2010-6, ball radius 0.5 mm
Cutting method: Bottom cutting
Work material: STAVAX (52 HRC) (manufactured by Bohler-Uddeholm Co., Ltd.)
Depth of cut: 0.04 mm in an axial direction, 0.04 mm in a radial direction
Cutting speed: 75.4 m/min
One blade feed amount: 0.018 mm/blade
Cutting distance: 15 m
Evaluation method: After cutting, the work material was observed using a scanning electron microscope at a magnification of 1000 times to measure widths of abrasion between the tool and the work material on a flank face of the tool, and a portion having the largest abrasion width thereamong was defined as a flank face maximum wear width.

**[Table 1]**

| Sample No | Flank face maximum wear width (µm) |
|---|---|
| Example 1 | 9 |
| Comparative Example 1 | 18 |

Example 1 having the above-described microstructure had a small flank face maximum wear width and had more excellent durability than that of Comparative Example 1. It is presumed that Example 1 contained a large amount of Al, whereby damage to the tool is suppressed.

## Claims

1. A coated tool comprising:
a substrate; and
a hard coating on the substrate,
wherein the hard coating includes an A layer provided on the substrate and a B layer provided on the A layer,
the A layer is a nitride or a carbonitride containing 50 atom% or more and 70 atom% or less of Al and 30 atom% or more and 50 atom% or less of Cr with respect to a total amount of metal elements including metalloid elements,
the B layer is a nitride or a carbonitride containing 70 atom% or more and 85 atom% or less of Al and 15 atom% or more and 30 atom% or less of Cr with respect to a total amount of metal elements including metalloid elements,
the B layer is finer than the A layer,
in the B layer, streaky phases having different brightnesses are confirmed in observation with a transmission electron microscope,
the phases having different brightnesses have a region having a relatively high Al content and a region having a relatively low Al content, and
the A layer and the B layer contain Ar.
